(19) **Europäisches Patentamt / European Patent Office / Office européen des brevets**

(11) **EP 2 907 237 B1**

(12) **FASCICULE DE BREVET EUROPEEN**

(45) Date de publication et mention de la délivrance du brevet:
**06.07.2016 Bulletin 2016/27**

(21) Numéro de dépôt: **13774460.3**

(22) Date de dépôt: **11.10.2013**

(51) Int Cl.:
*H03K 17/96* (2006.01)    *A45D 33/32* (2006.01)

(86) Numéro de dépôt international:
**PCT/EP2013/071351**

(87) Numéro de publication internationale:
**WO 2014/057121 (17.04.2014 Gazette 2014/16)**

(54) **RECIPIENT POUR LE STOCKAGE D'UN FLUIDE DESTINE A INTERAGIR AVEC UN UTILISATEUR**

BEHÄLTER ZUM AUFBEWAHREN EINER ZUR INTERAKTION MIT EINEM BENUTZER DIENENDEN FLÜSSIGKEIT

RECIPIENT FOR STORING A FLUID INTENDED TO INTERACT WITH A USER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.10.2012 FR 1259765**

(43) Date de publication de la demande:
**19.08.2015 Bulletin 2015/34**

(73) Titulaire: **Commissariat à l'Energie Atomique et aux Energies Alternatives**
**75015 Paris (FR)**

(72) Inventeurs:
• **MAINGUET, Jean-François**
  **F-38100 Grenoble (FR)**

• **ARRIZABALAGA, Gorka**
  **F-38250 Lans en Vercors (FR)**
• **AUBOUY, Miguel**
  **F-38000 Grenoble (FR)**

(74) Mandataire: **Guérin, Jean-Philippe et al**
**Innovation Competence Group**
**310 bis avenue Berthelot**
**69008 Lyon (FR)**

(56) Documents cités:
| | |
|---|---|
| EP-A1- 1 792 781 | FR-A1- 2 967 271 |
| US-A1- 2005 001 633 | US-A1- 2010 038 382 |
| US-A1- 2011 182 458 | US-B1- 6 452 494 |

## Description

L'invention concerne les récipients, et en particulier les récipients destinés à recevoir du fluide et à interagir avec un utilisateur.

Des bouteilles sont notamment utilisées comme récipients pour stocker des produits de consommation, tels que des boissons ou des parfums. Par exemple, les parfums sont le plus souvent distribués dans des flacons munis de bouchons et permettant d'éviter le déversement incontrôlé du parfum stocké. Il existe une demande croissante pour que le flacon interagisse avec l'utilisateur, en générant par exemple un signal lumineux lorsque l'utilisateur manipule le flacon. De tels flacons sont par exemple souhaités pour démarquer un type de parfum de la concurrence.

Un flacon connu comporte un bouchon et un éclairage par diode électroluminescente. Lors de la manipulation d'un interrupteur du bouchon, la diode électroluminescente émet un signal lumineux.

Un tel éclairage présente des fonctionnalités relativement limitées. L'intensité lumineuse émise par un tel flacon ne prend notamment pas en compte la distance avec l'utilisateur, car basée seulement sur un mode tout ou rien. D'autre part, un tel flacon ne génère de la lumière que lorsque l'utilisateur agit sur le bouchon et ne permet pas de créer un éclairage différencié pour la manipulation d'autres zones du flacon. En outre, un tel éclairage ne réagit qu'à la manipulation d'un interrupteur et non à des gestes plus simples tels que le simple maintien du flacon.

Il n'existe pas à ce jour de système apte à détecter une action entre un utilisateur et une surface d'un récipient sans nécessiter une modification considérable du procédé de fabrication et sans induire un surcoût considérable. Les récipients sont donc le plus souvent inertes et sans interaction avec l'utilisateur suite à une action de celui-ci.

Le document EP1792781 décrit un dispositif de commutation pour détecter l'introduction de la main d'un utilisateur dans un vide-poche d'un véhicule. Le vide-poche présente une paroi de panneau intérieur de porte présentant une ouverture pour introduire un objet dans le bac. Le bac est revêtu d'une électrode de mesure, connectée à un dispositif de mesure de la capacité. En fonction de la mesure de capacité réalisée, un interrupteur commande l'éclairage du bac par une lampe.

Le document US2005/0001633 décrit un capteur de détection de contact insensible à la présence d'une goutte de pluie sur le capteur. Pour cela, ce capteur détecte la capacité d'un utilisateur avec le sol, ce qui permet de discriminer l'utilisateur d'une goutte totalement isolée du sol.

L'invention vise à résoudre un ou plusieurs de ces inconvénients. L'invention porte ainsi sur un récipient pour le stockage d'un objet, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :

- la figure 1 est une vue en perspective schématique d'un flacon selon un mode de réalisation de l'invention ;
- la figure 2 est une vue en coupe schématique du flacon en présence du doigt d'un utilisateur, à distance d'un élément de détection ;
- la figure 3 est une vue en coupe schématique du flacon au niveau d'un élément de détection ;
- la figure 4 est un schéma électrique équivalent du flacon et d'un circuit le contrôle en présence du doigt de l'utilisateur ;
- la figure 5 représente schématiquement un circuit de contrôle connecté à plusieurs éléments de détection indépendants ;
- la figure 6 est une vue de face d'une variante de flacon au niveau d'un élément de détection ;
- la figure 7 est une vue en coupe du flacon de la figure 6 au niveau de l'élément de détection ;
- la figure 8 est une vue de dessus du conteneur d'un flacon selon un autre mode de réalisation de l'invention ;
- la figure 9 est une vue de dessous d'un cabochon associé au conteneur de la figure 8 ;
- la figure 10 illustre schématiquement la connectique d'un exemple de microcontrôleur du circuit de contrôle.

L'invention propose un récipient, incluant un conteneur isolant électrique, et destiné à interagir avec un utilisateur. Pour cela, une couche conductrice électriquement est disposée sur une surface du conteneur. On mesure la capacité formée entre la couche conductrice et un objet rapproché et chargé électriquement. Cette mesure est réalisée par l'intermédiaire d'un élément de détection électriquement conducteur et couplé capacitivement à la couche conductrice. Un signal de commande est généré en fonction de la capacité mesurée. Ce signal de commande peut être appliqué sur un transducteur, par exemple un haut-parleur, une source lumineuse ou un actionneur.

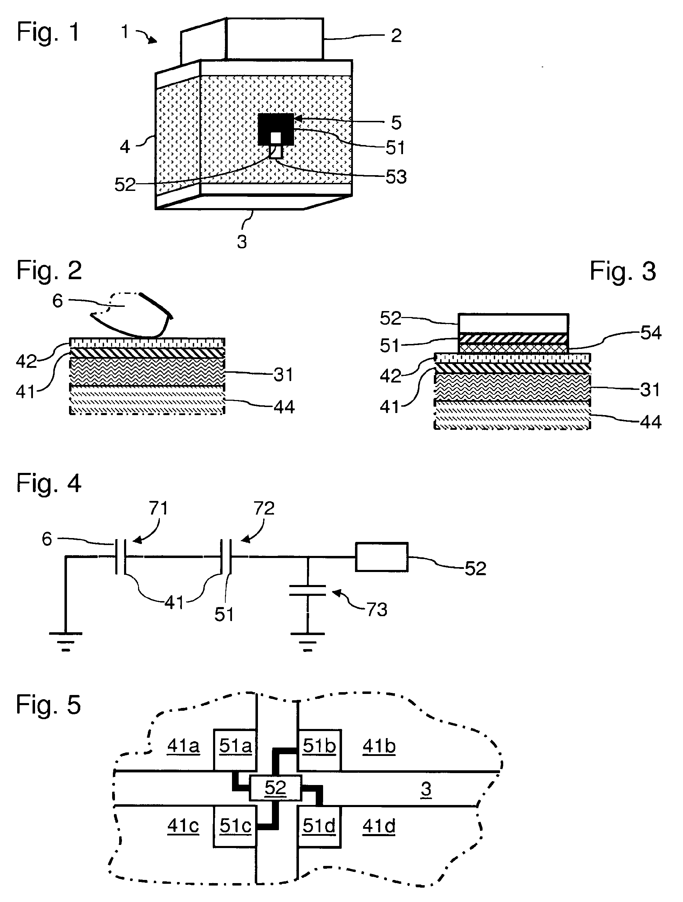

La figure 1 est une vue en perspective schématique d'un flacon 1 selon un mode de réalisation de l'invention. Le flacon 1 est destiné à stocker un objet. Dans l'exemple décrit, l'objet est une poudre ou un fluide cosmétique 44, tel que du parfum ou une crème. Bien que les exemples décrits par la suite portent uniquement sur un flacon, l'invention s'applique bien entendu à tout autre récipient, tel qu'une bouteille destinée à contenir une boisson ou un étui renfermant un objet.

Le flacon 1 comprend de façon connue en soi un conteneur 3 destiné à contenir un fluide. Le conteneur 3 comporte une paroi 31 délimitant un volume intérieur. La paroi 31 est isolante électriquement. La paroi 31 peut par exemple être réalisée en verre ou en matériau plastique. Le flacon 1 comprend de façon connue en soi un couvercle 2, en l'occurrence un cabochon.

Un empilement de couches 4 est disposé sur la face externe du conteneur 3. Cet empilement de couches 4 délimite une zone de détection d'une surface chargée électriquement, en particulier la main d'un utilisateur. L'empilement de couches 4 comprend d'une part une couche conductrice électriquement 41 et une couche d'isolant électrique 42. La couche conductrice électriquement 41 est disposée contre la face externe du conteneur 3. La couche d'isolant électrique 42 recouvre la couche conductrice 41.

La couche d'isolant électrique 42 permet d'une part de protéger la couche conductrice 41 des agressions mécaniques. La couche d'isolant électrique 42 permet d'autre part de former une capacité avec un objet chargé électriquement, par exemple le doigt 6 ou la main d'un utilisateur, comme illustré à la figure 3. Lorsque cet objet est suffisamment rapproché ou mis en contact avec la couche d'isolant 42, il forme une première électrode d'une capacité, l'autre électrode de la capacité étant formée par la couche conductrice 41.

Le flacon 1 comprend en outre un circuit de contrôle 5. Le circuit de contrôle 5 comprend d'une part un élément de détection 51, et d'autre part un circuit électronique 52 connecté électriquement à l'élément de détection 51. Le circuit de contrôle 5 génère sélectivement un signal de commande pour un transducteur 53.

La figure 3 est une vue schématique en coupe du flacon 1 au niveau de l'élément de détection 51. L'élément de détection 51 est conducteur électriquement et isolé de la couche conductrice 41, ici par l'intermédiaire de la couche d'isolant 42. L'élément de détection 51 est ici couplé capacitivement à la couche conductrice 41. L'élément de détection 51 forme ainsi une première électrode d'une capacité, l'autre électrode de la capacité étant formée par la couche conductrice 41.

La figure 4 représente un schéma électrique équivalent pour le flacon 1 en présence d'un doigt 6 sur ou à proximité de la couche d'isolant 42. La capacité 71 correspond à l'association du doigt 6 avec la couche conductrice 41. La capacité 72 correspond à l'association de la couche conductrice 41 avec l'élément de détection 51. Les capacités 71 et 72 sont ainsi connectées en série. Une capacité 73 est représentative des capacités parasites du flacon 1 et du circuit de contrôle 5.

Du fait des relativement faibles valeurs des capacités 71 et 72, l'homme du métier n'aurait pas privilégié une récupération de la variation de capacité induite par le doigt 6 par l'intermédiaire d'un couplage capacitif de l'élément de détection avec le circuit de contrôle 5. Selon des solutions usuelles de détection d'un doigt, la récupération de la variation de capacité est en effet effectuée par une connexion électrique entre une couche conductrice et un circuit électronique.

La structure illustrée est particulièrement appropriée pour un flacon 1 de parfum. En effet, il est courant de fabriquer des conteneurs 3 pour de tels flacons 1, ces conteneurs étant revêtus d'une couche métallique à des fins de décoration. Du fait de la finesse de cette couche métallique et de sa fragilité, celle-ci est usuellement recouverte d'une couche de vernis, qui se trouve être un isolant électrique. Ainsi, on peut noter qu'un certain nombre de conceptions de flacons incluent une couche conductrice sur le conteneur (couche métallique), revêtue d'une couche isolante (couche de vernis), à des fins de décoration. La couche d'isolant 42 permet de protéger la couche conductrice 41 relativement fine de la sueur corrosive des mains, de coulures de parfum, et également de l'oxygène de l'air à l'origine d'une oxydation. Cette structure forme donc intrinsèquement une première électrode et un isolant pour former une capacité avec la main ou le doigt d'un utilisateur. Du fait que la couche conductrice 41 recouvre la majeure partie de la surface externe du conteneur 3, la première électrode formée présente une très grande surface, facilitant la détection du doigt d'un utilisateur (sensibilité améliorée) et permettant potentiellement d'obtenir une capacité 71 d'une valeur relativement élevée. En positionnant un élément de détection 51 sur le vernis, le circuit de contrôle 5 peut réaliser une mesure de variation de capacité. On peut donc se passer d'une étape industrielle de retrait local du vernis ou de masquage de la couche métallique que nécessiterait une connexion électrique de la couche conductrice à un circuit de contrôle.

Ainsi, la couche d'isolant 42 fait office de matériau diélectrique pour former une première capacité 71, entre la main ou le doigt de l'utilisateur 6, et la couche conductrice 41, ainsi que pour former une deuxième capacité 72, entre ladite couche conductrice 41 et l'élément de détection 51.

Le circuit de contrôle 5 est avantageusement configuré mesurer la capacité formée entre la couche conductrice 41 et un objet chargé électriquement rapproché de cette couche 41, par exemple le doigt ou la main d'un utilisateur. Le circuit de contrôle 5 est en outre configuré pour générer un signal de commande en fonction de cette capacité mesurée, par exemple lorsque la valeur de capacité mesurée franchit un seuil.

Le signal de commande généré par le circuit de contrôle 5 est avantageusement appliqué sur le transducteur 53 afin d'obtenir une interaction appropriée avec l'utilisateur. Le transducteur 53 pourra par exemple être associé à un haut-parleur, une source lumineuse, ou un actionneur, par exemple un actionneur piézoélectrique d'une pompe de diffusion. Un transducteur 53 sera donc activé dans certaines circonstances, selon le souhait du concepteur.

La capacité 71 peut se définir par une capacité plane d'une surface de l'ordre de grandeur de la partie du doigt en contact avec le vernis 42 dans l'exemple de la figure 2. En prenant comme hypothèses que cette surface $S_{71}$ est de l'ordre de 2 cm$^2$, que la couche 42 présente une épaisseur $e_{71}$ de 25 microns (relativement épais pour un vernis de protection) et une permittivité relative $\varepsilon_{71}$ de 3, la valeur de la capacité 71 peut s'exprimer par la relation suivante :

$$C_{71} = \frac{\varepsilon_0 \varepsilon_{r71} S_{71}}{e_{71}}$$

Cette capacité C71 vaut alors approximativement 200 pF avec ces hypothèses.

La capacité 72 présente une valeur C72 qui peut se définir par une capacité plane d'une surface correspondant à la superposition entre l'élément de détection 51 et la couche conductrice 41. Cette surface est ici définie par la surface de l'élément de détection 51. En prenant comme hypothèses que cette surface $S_{72}$ est de l'ordre de 2 cm$^2$, que la couche 42 présente une épaisseur $e_{72} = e_{71} = 25$ microns et une permittivité relative $\varepsilon_{r72} = \varepsilon_{r71}$ de 3, la valeur de la capacité 72 peut s'exprimer par la relation suivante :

$$C_{72} = \frac{\varepsilon_0 \varepsilon_{r72} S_{72}}{e_{72}}$$

Cette capacité C72 vaut alors approximativement 200 pF avec ces hypothèses. Cette capacité C72 est avantageusement sensiblement équivalente à une valeur C71 que l'on souhaite détecter.

Ainsi, la capacité C71 est vue par le circuit de contrôle 5 à travers la capacité C 72. Les capacités 71 et 72 étant en série, leur capacité équivalente Ce est définie par la relation suivante :

$$C_e = \frac{C_{71} * C_{72}}{C_{71} + C_{72}}$$

On peut noter que la solution proposée par l'invention va à l'encontre de la démarche usuelle de l'homme du métier, puisque l'utilisation du couplage capacitif avec le circuit de contrôle 5 ajoute une capacité en série qui amoindrit sensiblement le signal mesuré par ce circuit de contrôle 5.

La capacité 73 forme une valeur parasite résiduelle C73, généralement de l'ordre de quelques pF mais peut atteindre quelques dizaines de pF. Ainsi le rapport entre C71 et C73 est ici approximativement égal à au moins 10. Une telle valeur permet de détecter aisément un contact entre un doigt 6 et la couche d'isolant 42.

On constate que la capacité équivalente Ce présente un ordre de grandeur environ cinq fois supérieur à la valeur C73. Par conséquent, le circuit de contrôle 5 conserve un signal d'entrée d'amplitude suffisante pour mesurer la capacité C71.

Le circuit de contrôle 5 connaissant approximativement les valeurs de capacité C72 et C73, il peut déterminer la valeur de la capacité C71 à partir de la tension mesurée sur son entrée.

On peut également envisager de détecter l'approche de la main d'un utilisateur du vernis 42. La main d'un utilisateur présente une surface approximative de 200 cm$^2$. En rapprochant la main à environ 1 cm de la couche de vernis 42, en reprenant la relation précédente de C71, en considérant que la permittivité de l'air est prépondérante ($\varepsilon_{r71} = 1$), la valeur C71 est d'environ de 20 pF. Cette capacité est du même ordre de grandeur que la capacité parasite. La détection devient alors plus difficile, et la distance à laquelle on détecte l'approche de la main se réduit ou ne s'effectue qu'au contact entre la main et le récipient.

On utilisera avantageusement un élément de détection 51 d'une surface au moins égale à 20 mm$^2$ pour une valeur C72 suffisante, la surface de l'élément de détection 51 étant limitée par l'encombrement maximal toléré pour cet élément.

Afin de faciliter la détection d'un contact entre un doigt 6 et la couche d'isolant 42, cette couche d'isolant 42 présente avantageusement un rapport $\varepsilon_{r71}/ e_{71}$ au moins égal à 100000. Afin de faciliter la détection de la proximité entre un doigt 6 et la couche d'isolant 42, cette couche d'isolant 42 présente avantageusement un rapport $\varepsilon_{r71}/ e_{71}$ au moins égal à 500000. On comprend que lorsque la permittivité relative de la couche d'isolant 42 est imposée, on peut jouer sur l'épaisseur $e_{71}$ de façon à obtenir le ratio $\varepsilon_{r71}/ e_{71}$ le plus élevé possible.

La figure 5 représente schématiquement un circuit de contrôle 5 muni d'un circuit électronique 52 connecté à plusieurs éléments de détection 51 a à 51 d. Les éléments de détection 51 a à 51 d sont conducteurs électriquement et isolés les uns des autres. La couche conductrice 41 comporte plusieurs parties conductrices 41 a à 41 d isolées électriquement les unes des autres. Les éléments de détection 51 a à 51 d sont couplés capacitivement aux parties conductrices 41 a à 41 d respectivement. La couche d'isolant 42 est ainsi disposée entre les parties conductrices 41 a à 41 d et les éléments de détection 51 a à 51 d. Le circuit de contrôle 5 est configuré pour mesurer la capacité formée entre chacune de ces parties conductrices 41 a à 41 d et un objet chargé électriquement rapproché d'une de ces parties. Le circuit de contrôle 5 est en outre configuré pour générer un signal de commande en fonction des différentes capacités mesurées. Ainsi, le circuit de contrôle 5 est capable de générer des signaux de commande pour tenir compte de différentes zones d'interactions entre l'utilisateur et le conteneur 3.

Les différentes parties conductrices 41 a à 41 d peuvent délimiter différentes zones de détection du conteneur 3, par exemple le fond, une paroi avant, une paroi arrière ou un goulot. Les différentes parties conductrices 41 a à 41 d de la couche conductrice 41 peuvent par exemple être réalisées par un retrait du dépôt métallique par l'intermédiaire d'un faisceau laser, procédé connu en soi pour mettre en forme une couche métallique de décoration pour un flacon de parfum. Afin d'accroître la sensibilité de la détection par le circuit de contrôle 5, la réunion des différentes parties conductrices 41 a à 41 d recouvre au moins la partie du conteneur 3 (c'est-à-dire au moins 50 % de sa surface externe).

Dans cet exemple, l'élément de détection 51 est fixé contre la couche d'isolant 42 par l'intermédiaire d'une couche d'adhésif 54, avantageusement une couche d'adhésif conducteur afin de ne pas diminuer la capacité formée par la couche 41 et l'élément de détection 51. On peut envisager de positionner le circuit de contrôle 5 avec son élément de détection 51 dans une étiquette adhésive. Si un mode de fixation par adhésion de l'élément de détection 51 à la couche d'isolant 42 a été décrit précédemment, on peut également envisager de mettre en oeuvre l'invention par toute autre mode de fixation, par exemple par un maintien mécanique.

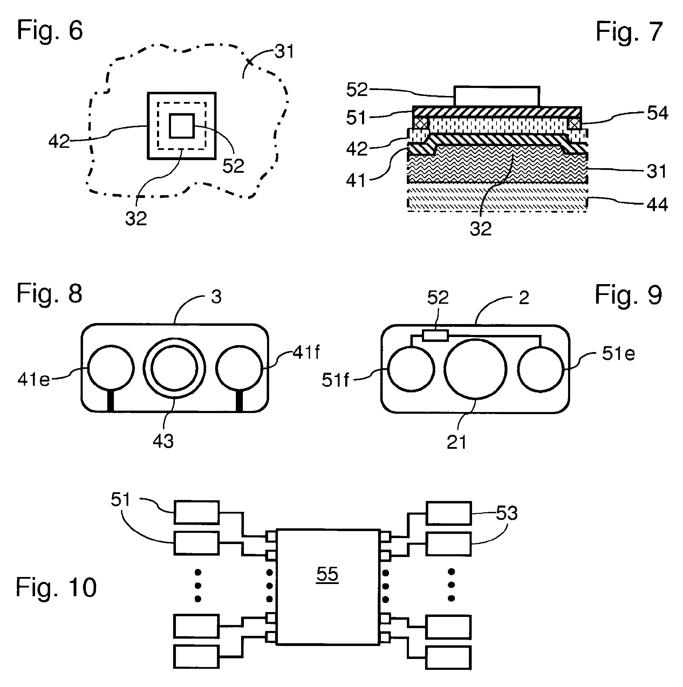

Les figures 6 et 7 sont respectivement des vues schématiques de côté et en coupe transversale d'une variante de l'invention destinée à améliorer la qualité de la mesure effectuée. Le conteneur 3 comporte une bosse 32. La paroi 31 du conteneur 3 est recouverte par la couche conductrice 41 au niveau de la bosse 32 et épouse donc la forme de la bosse. La couche conductrice 41 est recouverte par la couche d'isolant 42 au niveau de la bosse 32, et épouse donc la forme de la bosse. La périphérie de la bosse 32 est entourée par un cordon d'adhésif 54, la face supérieure de la bosse 32 n'étant pas recouverte par cet adhésif 54. L'élément de détection 51 est fixé à la couche d'isolant 42 par l'intermédiaire de cet adhésif 54. La majeure partie de l'élément de détection 51 est positionnée à l'aplomb de la bosse 32. Ainsi, la distance entre l'élément de détection 51 et la couche conductrice 41 n'est pas augmentée par l'épaisseur de la couche d'adhésif.

D'autres modes de réalisation sont possibles, le bossage 32 pouvant être réalisé sur la couche 41 et/ou sur l'élément de détection 51, ou sans bossage particulier en s'arrangeant pour que l'élément de détection 51 vienne en contact avec la couche isolante 42 sans introduction de lame d'air malgré la surépaisseur du cordon de colle, par exemple sous vide ou par effort mécanique adéquat, par exemple à l'aide d'un moyen d'application d'une pression, en particulier un ressort.

Les figures 8 et 9 sont respectivement une vue schématique de dessus d'un conteneur 3 et une vue schématique de dessous d'un cabochon 2 pour un récipient 1 selon un autre mode de réalisation de l'invention. Le conteneur 3 comporte des parties conductrices recouvertes d'une couche d'isolant sur une face avant. Ces parties conductrices sont connectées respectivement à des pastilles conductrices 41e et 41f par l'intermédiaire de pistes conductrices métalliques. Les pastilles conductrices 41e et 41f sont disposées de part et d'autre d'un goulot 43, dans la partie supérieure du conteneur 3.

Le cabochon 2 comporte un orifice 21 dans sa partie médiane. Le cabochon 2 est destiné à se monter de façon amovible sur le conteneur 3 par coulissement du goulot 43 dans l'orifice 21. L'orifice 21 est destiné à loger le goulot 43 du conteneur 3. Le cabochon 2 comporte des éléments de détection 51 e et 51 f venant se positionner en vis-à-vis des pastilles 41 e et 41 f, lorsque le cabochon 2 est en position fermée, c'est-à-dire lorsque le goulot 43 est introduit dans l'orifice 21. Le circuit électronique 52 est ici avantageusement ménagé dans le cabochon 2, et connecté électriquement aux éléments de détection 51 e et 51 f. Il existe ainsi moins de contraintes d'encombrement sur le circuit électronique 52. L'interaction des transducteurs 53 peut également être plus importante, le cabochon 2 comportant généralement suffisamment de place pour intégrer des fonctions plus complexes telles qu'un éclairage.

On peut également envisager de réaliser des parties de la couche conductrice 41 au niveau du goulot 43, en lieu et place des pastilles 41 e et 41 f. Des éléments de détection sont alors ménagés dans l'orifice 21 afin de former un couplage capacitif avec la partie métallisée du goulot lorsque le cabochon 2 est emboîté sur la partie supérieure du conteneur 3.

On peut par ailleurs envisager que le circuit de contrôle 5 soit intégré dans un bloc de pulvérisateur emboîté au sommet du conteneur 3.

On remarquera que lorsque le cabochon 2 est séparé du récipient, la capacité $C_{72}$ disparaît, ce qui est aisément détecté par le circuit électronique 52 de manière différente d'un contact où la capacité augmente. On peut alors détecter un retrait du cabochon 2 ou, de façon plus générale, un éloignement ou un rapprochement de ce dernier par rapport au conteneur 3 et générer un signal de commande correspondant à cette détection..

Le circuit électronique 52 comporte avantageusement un microcontrôleur. Dans l'exemple illustré à la figure 10, le microcontrôleur 55 comporte plusieurs entrées pour la mesure de différentes capacités. Ainsi, plusieurs éléments de détection 51 sont connectés à des rentrées respectives du microcontrôleur 55, et superposés à des parties conductrices respectives de la couche conductrice 41. Les sorties du microcontrôleur 55 peuvent être connectées à des transducteurs respectifs 53. Les transducteurs 53 peuvent être associés à des entrées respectives du microcontrôleur 55.

On peut aisément adapter un microcontrôleur 55 tel que le modèle commercialisé sous la référence commerciale MSP430 par la société Texas Instruments. Un tel microcontrôleur 55 comporte plusieurs entrées destinées à chacune recevoir un signal représentatif d'une variation capacitive du fait du contact du doigt d'un utilisateur avec la couche d'isolant 42 à l'aplomb de la couche conductrice 41. Un tel microcontrôleur 55 peut utiliser des entrées en mode oscillateur à relaxation. Ainsi, chaque entrée considérée entre en oscillation du fait d'un bouclage en opposition de phase réalisé à l'intérieur du microcontrôleur 55. La capacité mesurée a une influence sur un résonateur RC formé avec l'entrée du microcontrôleur 55, la constante de temps de ce résonateur permettant de déterminer la valeur de la capacité mesurée. La fréquence peut notamment être déterminée en comptant un nombre d'oscillations pendant une durée déterminée. Les entrées du microcontrôleur 55 peuvent être connectées par des pistes conductrices métalliques (par exemple des pistes conductrices en cuivre) à des éléments de détection respectifs.

Avantageusement, pour de nombreuses applications de produits distribués dans le commerce, l'empilement des couches 4 permet de distinguer le fluide 44 depuis l'extérieur du conteneur 3. Pour cela, des choix de matériaux et d'épaisseurs appropriées seront effectuées pour les couches 41 et 42. On pourra par exemple envisager que la couche conductrice, ou l'empilement de la couche conductrice 41 et de la couche d'isolant 42 présentent une transmittance optique au moins égale à 60 % sur le spectre visible.

## Revendications

1. Récipient (1) pour le stockage d'un objet, **caractérisé en ce qu**'il comprend :

   - un conteneur (3) isolant électrique, destiné à contenir l'objet ;
   - une couche conductrice électriquement (41), disposée sur la face externe du conteneur, la couche conductrice étant recouverte d'une couche d'isolant électrique (42) ;
   - un circuit de contrôle (52) comportant un élément de détection (51) électriquement conducteur, isolé électriquement de ladite couche conductrice et couplé capacitivement à ladite couche conductrice, la couche d'isolant électrique étant disposée entre ladite couche conductrice (41) et ledit élément de détection (51), ledit circuit de contrôle étant configuré pour :

     - mesurer la capacité formée entre ladite couche conductrice et un objet chargé électriquement rapproché de la couche conductrice ;
     - générer un signal de commande en fonction de la capacité mesurée.

2. Récipient (1) pour le stockage d'un objet, **caractérisé en ce qu**'il comprend :

   - un conteneur (3) isolant électrique, destiné à contenir l'objet ;
   - une couche conductrice électriquement (41), disposée sur la face externe du conteneur, la couche conductrice étant recouverte d'une couche d'isolant électrique (42) ;
   - un circuit de contrôle (52) comportant un élément de détection (51) électriquement conducteur, isolé électriquement de ladite couche conductrice et couplé capacitivement à ladite couche conductrice, la couche d'isolant électrique étant disposée entre ladite couche conductrice (41) et ledit élément de détection (51), ledit circuit de contrôle étant configuré pour :

     - mesurer l'évolution de la capacité formée entre ladite couche conductrice (41) et ledit élément de détection (51) ;
     - générer un signal de commande en fonction de ladite évolution mesurée.

3. Récipient selon la revendication 2, le circuit de contrôle (52) étant disposé dans un couvercle (2) adapté au conteneur (3), de telle sorte que le signal de commande est généré lorsque le couvercle s'éloigne ou se rapproche dudit conteneur (3).

4. Récipient (1) selon l'une quelconque des revendications précédentes, dans lequel ladite couche conductrice (41) recouvre la majeure partie dudit conteneur (3).

5. Récipient (1) selon l'une quelconque des revendications précédentes, dans lequel ladite couche conductrice (41) comporte plusieurs parties (41 a, 41 b, 41 c, 41 d) isolées électriquement les unes des autres, ledit circuit de contrôle (52) comportant plusieurs éléments de détection électriquement conducteurs (51 a, 51 b, 51 c, 51 d) isolés électriquement de chacune desdites parties de la couche conductrice, chacun desdits éléments de détection étant couplé capacitivement à une partie respective de ladite couche conductrice, ledit circuit de contrôle (52) étant configuré pour mesurer la capacité formée entre chacune desdites parties de la couche conductrice et un objet chargé électriquement rapproché d'une desdites parties, et configuré pour générer un signal de commande en fonction desdites capacités mesurées.

6. Récipient (1) selon la revendication 5, dans lequel la réunion desdites parties de la couche conductrice (41) recouvre la majeure partie du conteneur (3).

7. Récipient (1) selon l'une quelconque des revendications précédentes, dans lequel ladite couche d'isolant (42) présente un rapport $\varepsilon r/e$ supérieur à 100000, avec $\varepsilon r$ la permittivité relative du matériau de la couche d'isolant et e l'épaisseur de la couche d'isolant.

8. Récipient (1) selon la revendication 7, dans lequel ladite couche d'isolant (42) présente un rapport $\varepsilon r/e$ supérieur à 500000, avec $\varepsilon r$ la permittivité relative du matériau de la couche d'isolant (42) et e l'épaisseur de la couche d'isolant (42).

9. Récipient (1) selon l'une quelconque des revendications précédentes, dans lequel ledit élément de détection (51) est collé sur la couche d'isolant par l'intermédiaire d'un adhésif conducteur (54).

10. Récipient (1) selon l'une quelconque des revendications précédentes, dans lequel ledit élément de détection (51) est une surface conductrice d'une superficie au moins égale à 20mm$^2$ disposée en vis-à-vis de ladite couche conductrice (41).

11. Récipient (1) selon l'une quelconque des revendications précédentes, comprenant en outre un couvercle (2) configuré pour être solidarisé de façon amovible au conteneur (3), le circuit de contrôle (52) étant fixé au couvercle (2), le couvercle (2) présentant une position de solidarisation au conteneur (3) dans laquelle ledit élément de détection (51) est en vis-à-vis de ladite couche conductrice (41) et est couplé capacitivement à ladite couche conductrice.

12. Récipient (1) selon l'une quelconque des revendications précédentes, dans lequel ledit circuit (52) comprend un microcontrôleur (55) dont au moins une borne d'entrée est connectée électriquement audit élément de détection (51).

13. Récipient (1) selon l'une quelconque des revendications précédentes, dans lequel le conteneur (3) contient un produit cosmétique, notamment du parfum (44) ou de la crème.

14. Récipient (1) selon l'une quelconque des revendications précédentes, dans lequel ladite couche conductrice (41) présente une transmittance optique au moins égale à 60% sur le spectre visible.

15. Récipient (1) selon l'une quelconque des revendications précédentes, comprenant en outre un transducteur (53) configuré pour recevoir le signal de commande généré.

**Patentansprüche**

1. Behälter (1) zum Aufbewahren eines Gegenstands, **dadurch gekennzeichnet, dass** er Folgendes umfasst:

   - einen elektrisch isolierenden Container (3), der dazu bestimmt ist, den Gegenstand zu enthalten;
   - eine elektrisch leitende Schicht (41), die auf der Oberfläche des Containers angeordnet ist, wobei die leitende Schicht von einer elektrischen Isolatorschicht (42) bedeckt ist;
   - eine Steuerungsschaltung (52), umfassend ein elektrisch leitendes Erfassungselement (51), das von der leitenden Schicht elektrisch isoliert und mit der leitenden Schicht kapazitiv verbunden ist, wobei die elektrische Isolatorschicht zwischen der leitenden Schicht (41) und dem Erfassungselement (51) angeordnet ist, wobei die Steuerungsschaltung konfiguriert ist, um:

   - die Kapazität zu messen, die zwischen der leitenden Schicht und einem elektrisch geladenen Gegenstand gebildet wird, der in die Nähe der leitenden Schicht gebracht wird;
   - ein Steuerungssignal in Abhängigkeit von der gemessenen Kapazität zu erzeugen.

2. Behälter (1) zum Aufbewahren eines Gegenstands, **dadurch gekennzeichnet, dass** er Folgendes umfasst:

   - einen elektrisch isolierenden Container (3), der dazu bestimmt ist, den Gegenstand zu enthalten;
   - eine elektrisch leitende Schicht (41), die auf der Oberfläche des Containers angeordnet ist, wobei die leitende Schicht von einer elektrischen Isolatorschicht (42) bedeckt ist;
   - eine Steuerungsschaltung (52), umfassend ein elektrisch leitendes Erfassungselement (51), das von der leitenden Schicht elektrisch isoliert und mit der leitenden Schicht kapazitiv verbunden ist, wobei die elektrische Isolatorschicht zwischen der leitenden Schicht (41) und dem Erfassungselement (51) angeordnet ist, wobei die Steuerungsschaltung konfiguriert ist, um:
   - die Entwicklung der Kapazität zu messen, die zwischen der leitenden Schicht (41) und dem Erfassungselement (51) gebildet wird;
   - ein Steuerungssignal in Abhängigkeit von der gemessenen Entwicklung zu erzeugen.

3. Behälter nach Anspruch 2, wobei die Steuerungsschaltung (52) in einem Deckel (2), der an den Container (3) angepasst ist, derart angeordnet ist, dass das Steuerungssignal erzeugt wird, wenn sich der Deckel von dem Container (3) entfernt oder sich diesem nähert.

4. Behälter (1) nach einem der vorhergehenden Ansprüche, wobei die leitende Schicht (41) den größten Teil des Containers (3) bedeckt.

5. Behälter (1) nach einem der vorhergehenden Ansprüche, wobei die leitende Schicht (41) mehrere Abschnitte (41 a, 41 b, 41 c, 41 d) umfasst, die elektrisch voneinander isoliert sind, wobei die Steuerungsschaltung (52) mehrere elektrisch leitende Erfassungselemente (51 a, 51 b, 51 c, 51 d) umfasst, die von jedem der Abschnitte der leitenden Schicht elektrisch isoliert sind, wobei jedes der Erfassungselemente mit einem jeweiligen Abschnitt der leitenden Schicht kapazitiv verbunden ist, wobei die Steuerungsschaltung (52) konfiguriert ist, um die Kapazität zu messen, die zwischen jedem der Abschnitte der leitenden Schicht und einem elektrisch geladenen Gegenstand gebildet wird, der sich einem der Abschnitte nähert, und konfiguriert ist, um ein Steuerungssignal in Abhängigkeit von den gemessenen Kapazitäten zu erzeugen.

6. Behälter (1) nach Anspruch 5, wobei die Verbindung der Abschnitte der leitenden Schicht (41) den größten Teil des Containers (3) bedeckt.

7. Behälter (1) nach einem der vorhergehenden Ansprüche, wobei die Isolatorschicht (42) ein Verhältnis $\varepsilon r/e$ größer 100.000 aufweist, wobei $\varepsilon r$ für die relative Permittivität des Materials der isolierenden Schicht steht und e für die Dicke der isolierenden Schicht steht.

8. Behälter (1) nach Anspruch 7, wobei die Isolatorschicht (42) ein Verhältnis $\varepsilon r/e$ größer 500.000 aufweist, wobei $\varepsilon r$ für die relative Permittivität des Materials der isolierenden Schicht (42) steht und e für die Dicke der isolierenden Schicht (42) steht.

9. Behälter (1) nach einem der vorhergehenden Ansprüche, wobei das Erfassungselement (51) mithilfe eines leitenden Klebstoffs (54) auf die Isolatorschicht geklebt ist.

10. Behälter (1) nach einem der vorhergehenden Ansprüche, wobei das Erfassungselement (51) eine leitende Oberfläche mit einer Fläche von mindestens gleich 20 mm$^2$ ist, die gegenüber der leitenden Schicht (41) angeordnet ist.

11. Behälter (1) nach einem der vorhergehenden Ansprüche, ferner umfassend einen Deckel (2), der konfiguriert ist, um lösbar mit dem Container (3) verbunden zu werden, wobei die Steuerungsschaltung (52) an dem Deckel (2) befestigt ist, wobei der Deckel (2) eine Verbindungsposition mit dem Container (3) aufweist, in der sich das Erfassungselement (51) gegenüber der leitenden Schicht (41) befindet und mit der leitenden Schicht kapazitiv verbunden ist.

12. Behälter (1) nach einem der vorhergehenden Ansprüche, wobei die Schaltung (52) einen Mikrocontroller (55) umfasst, dessen mindestens eine Eingangsklemme elektrisch an das Erfassungselement (51) angeschlossen ist.

13. Behälter (1) nach einem der vorhergehenden Ansprüche, wobei der Container (3) ein Kosmetikprodukt, insbesondere Parfum (44) oder Creme, enthält.

14. Behälter (1) nach einem der vorhergehenden Ansprüche, wobei die leitende Schicht (41) eine optische Transmission von mindestens gleich 60 % im sichtbaren Spektrum aufweist.

15. Behälter (1) nach einem der vorhergehenden Ansprüche, ferner umfassend einen Transducer (53), der konfiguriert ist, um das erzeugte Steuerungssignal zu empfangen.

## Claims

1. Vessel (1) for storing an object, **characterized in that** it comprises:

   - an electrically insulating container (3), intended to contain the object;
   - an electrically conductive layer (41), arranged on the outer face of the container, the conductive layer being covered with an electrically insulating layer (42);
   - a control circuit (52) comprising an electrically conductive detection element (51), electrically insulated from said conductive layer and capacitively coupled to said conductive layer, the electrically insulating layer being arranged between said conductive layer (41) and said detection element (51), said control circuit being configured to:

      - measure the capacitance formed between said conductive layer and an electrically charged object brought close to the conductive layer;
      - generate a control signal dependent on the measured capacitance.

2. Vessel (1) for storing an object, **characterized in that** it comprises:

   - an electrically insulating container (3), intended to contain the object;
   - an electrically conductive layer (41), arranged on the outer face of the container, the conductive layer being covered with an electrically insulating layer (42);
   - a control circuit (52) comprising an electrically conductive detection element (51), electrically insulated from said conductive layer and capacitively coupled to said conductive layer, the electrically insulating layer being arranged between said conductive layer (41) and said detection element (51), said control circuit being configured to:

      - measure the trend of the capacitance formed between said conductive layer (41) and said detection element (51);
      - generate a control signal dependent on said measured trend.

3. Vessel according to Claim 2, the control circuit (52) being arranged in a cover (2) matched to the container (3), such that the control signal is generated when the cover is moved away from or brought close to said container (3).

4. Vessel (1) according to any one of the preceding claims, in which said conductive layer (41) covers most of said container (3).

5. Vessel (1) according to any one of the preceding claims, in which said conductive layer (41) comprises a number of parts (41a, 41b, 41c, 41d) electrically insulated from one another, said control circuit (52) comprising a number of electrically conductive detection elements (51a, 51b, 51c, 51d) electrically insulated from each of said parts of the conductive layer, each of said detection elements being capacitively coupled to a respective part of said conductive layer, said control circuit (52) being configured to measure the capacitance formed between each of said parts of the conductive layer and an electrically charged object brought close to one of said parts, and configured to generate a control signal dependent on said measured capacitances.

6. Vessel (1) according to Claim 5, in which the combination of said parts of the conductive layer (41) covers most of the container (3).

7. Vessel (1) according to any one of the preceding claims, in which said insulating layer (42) exhibits a ratio $\varepsilon r/e$ greater than 100 000, with $\varepsilon r$ being the relative permittivity of the material of the insulating layer and e being the thickness of the insulating layer.

8. Vessel (1) according to Claim 7, in which said insulating layer (42) exhibits a ratio $\varepsilon r/e$ greater than 500 000, with $\varepsilon r$ being the relative permittivity of the material of the insulating layer (42) and e being the thickness of the insulating layer (42).

9. Vessel (1) according to any one of the preceding claims, in which said detection element (51) is glued onto the insulating layer via a conductive adhesive (54).

10. Vessel (1) according to any one of the preceding claims, in which said detection element (51) is a conductive surface with a surface area at least equal to 20 mm$^2$ arranged facing said conductive layer (41).

11. Vessel (1) according to any one of the preceding claims, further comprising a cover (2) configured to be secured removably to the container (3), the control circuit (52) being fixed to the cover (2), the cover (2) having a position of securing to the container (3) in which said detection element (51) is facing said conductive layer (41) and is capacitively coupled to said conductive layer.

12. Vessel (1) according to any one of the preceding claims, in which said circuit (52) comprises a microcontroller (55) of which at least one input terminal is electrically connected to said detection element (51).

13. Vessel (1) according to any one of the preceding claims, in which the container (3) contains a cosmetic product, notably perfume (44) or cream.

14. Vessel (1) according to any one of the preceding claims, in which said conductive layer (41) exhibits an optical transmittance at least equal to 60% over the visible spectrum.

15. Vessel (1) according to any one of the preceding claims, further comprising a transducer (53) configured to receive the generated control signal.

Fig. 1

1 ↗

2

5

51

4

53

52

3

Fig. 2

Fig. 3

6

42

41

31

44

52

51

42

41

54

31

44

Fig. 4

71

72

6

41

51

52

73

Fig. 5

41a

51a

51b

41b

52

3

41c

51c

51d

41d

Fig. 6

Fig. 7

Fig. 8

Fig. 9

Fig. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1792781 A
- US 20050001633 A